# EUROPEAN PATENT SPECIFICATION

(11) **EP 4 572 339 B1**
(45) Date of publication and mention of the grant of the patent: **04.11.2026**
(21) Application number: 25174162.5
(22) Date of filing: 06.08.2021
(51) Int. Cl.: H04R 1/10, H04R 1/28, H04R 25/00

(54) **EARPIECE PORTING**
HÖRERPORTIERUNG
RÉALISATION D'ORIFICES D'OREILLETTE

(30) Priority: 11.08.2020 US 202016990358
(43) Date of publication of application: 18.06.2025
(60) Divisional application: 26207071.7
(62) Document number(s) of the earlier application(s) in accordance with Art. 76 EPC: 21762300.8 / 4 197 198
(73) Proprietor: Bose Corporation, Framingham, MA 01701-9168 (US)
(72) Inventor: DALEY, Michael J., Framingham, 01701-9168 (US); CHENG, Lei, Framingham, 01701-9168 (US); GADRE, Ninad, Framingham, 01701-9168 (US); MORIARTY, Peter McPhillips, Framingham, 01701-9168 (US); ENTE, Shaun Douglas, Framingham, 01701-9168 (US); MCKEE, Matthew M., Framingham, 01701-9168 (US); DOMINIJANNI, Andrew D., Framingham, 01701-9168 (US)
(74) Representative: Attali, Pascal

(56) References cited:
- EP-A1- 3 672 279
- US-A1- 2012 201 406
- US-A1- 2014 348 372
- US-A1- 2019 253 813
- US-A1- 2019 394 577

## Description

### BACKGROUND

This disclosure relates to earpiece porting.

EP 3 672 279 A1, US 2014/348372 A1, US 2017/223443 A1, US 2012/201406 A1 and EP 2 765 788 A2 disclose prior art earpieces.

### SUMMARY

The present invention is defined by the independent claims. Advantageous embodiments are defined in the dependent claims.

In one aspect, an earpiece includes an electro-acoustic transducer and a housing. The housing supports the electro-acoustic transducer such that the housing and the electro-acoustic transducer together define a first acoustic volume and a second acoustic volume. The electro-acoustic transducer is arranged such that a first radiating surface of the transducer radiates acoustic energy into the first acoustic volume and such that a second radiating surface of the transducer radiates acoustic energy into the second acoustic volume. A front port couples the first acoustic volume to a space outside the housing, and a rear port couples the second acoustic volume to the space outside the housing. Respective outlet ends of the front port and the rear port combine before exiting the housing via a combined exit volume and an exit port.

In some implementations, the housing defines a nozzle and the first acoustic volume is acoustically coupled to an acoustic passage in the nozzle such that the electro-acoustic transducer is acoustically coupled to a user's ear canal when the earpiece is worn.

In certain implementations, the earpiece includes an ear tip supported on the nozzle and configured to form a tight acoustic seal with a user's ear canal when the earpiece is worn.

In some cases, the housing includes a receptacle for receiving wiring for powering the electro-acoustic transducer.

In certain cases, the exit port is covered with a mesh along an exterior surface of the housing.

In some examples, the exit port comprises a tube.

In certain examples, an outlet end of the tube is covered with a mesh.

In some implementations, the front port is formed integrally with the housing.

In certain implementations, a maximum pressure in the first acoustic volume when the exit port is sealed is between 100 dB SPL and 120 dB SPL.

In some cases, a maximum pressure in the first acoustic volume when the exit port is sealed is no greater than 132 dB SPL.

In certain cases, a hearing aid includes the earpiece, a casing, and wiring coupling the casing to the earpiece. The casing is configured to sit behind a user's pinna when worn.

In some examples, the hearing includes a battery, a microphone, and a sound processor housed in the casing.

In certain examples, the hearing aid also includes electronics housed within the casing and a microphone supported by the housing, and the wiring electrically couples the microphone to the electronics.

In some implementations, the wiring comprises flexible printed circuitry.

In certain implementations, the wiring electrically couples the electro-acoustic transducer to the electronics.

In some cases, the microphone is a feedback microphone arranged for picking up audio at the user's ear canal.

In certain cases, the microphone is a feedforward microphone arranged for picking up ambient noise in a region external to the housing for feedforward noise cancelation.

In some examples, the electronics are configured to execute an active noise cancellation algorithm that uses input from the microphone.

In certain examples, the earpiece includes a battery, a microphone, and a sound processor supported in the housing.

In some implementations, the electro-acoustic transducer includes a diaphragm defining the first and second radiating surfaces, and wherein the diaphragm has a diameter of less than 6 mm.

In certain implementations, the electro-acoustic transducer is a moving coil transducer.

In some cases, the hearing aid includes a battery; a first microphone; a sound processor; a transceiver; a second microphone; and wiring. The battery, the first microphone, the sound processor, and the transceiver are housed in the casing. The second microphone is supported by the housing and the wiring extends between the housing and the casing and electrically couples the second microphone to the sound processor.

In some examples, the sound processor is configured to execute an active noise cancellation algorithm that uses input from the second microphone.

In another aspect, an earpiece includes an electro-acoustic transducer and a housing that supports the electro-acoustic transducer. The housing and the electro-acoustic transducer together defining a first acoustic volume and a second acoustic volume. The electro-acoustic transducer is arranged such that a first radiating surface of the transducer radiates acoustic energy into the front acoustic volume, and such that a second radiating surface of the transducer radiates acoustic energy into the rear acoustic volume. A front port couples the first acoustic volume to space outside the housing and a rear port couples the second acoustic volume to the space outside the housing. A valve is provided over the front port and the rear port and arranged such that if the valve closes, it closes off the front port and the rear port separately.

Another aspect features a hearing aid that includes an electro-acoustic transducer, a microphone, and a housing supporting the electro-acoustic transducer and the microphone and sized to sit at least partially within a user's ear canal. The hearing aid also includes electronics, a casing supporting the electronics and configured to sit behind a user's pinna when worn, and wiring extending between the casing to the housing and electrically coupling the electronics to the electro-acoustic transducer and the microphone.

In some implementations, the electronics are configured to execute an active noise cancellation algorithm to produce a signal that causes the electro-acoustic transducer to produce acoustic energy to cancel noise based on input from the microphone.

Another aspect provides a hearing aid that includes an electro-acoustic transducer and a housing supporting the electro-acoustic transducer and sized to sit at least partially with in a user's ear canal. The hearing aid also includes electronics, a casing supporting the electronics and configured to sit behind a user's pinna when worn, wiring extending between the casing to the housing and electrically coupling the electronics to the electro-acoustic transducer, and a microphone supported by the housing. The electronics are configured to execute an active noise cancellation algorithm to produce a signal that causes the electro-acoustic transducer to produce acoustic energy to cancel noise based on input from the microphone.

In some implementations, the electro-acoustic transducer is a full range transducer.

In certain implementations, the electro-acoustic transducer is a moving coil transducer.

In some cases, the electronics include a transceiver that supports transmission of high-fidelity audio.

In certain cases, the microphone is supported by the housing and the wiring electrically couples the microphone to the electronics.

In some examples, the microphone is a feedback microphone arranged for picking up audio at the user's ear canal.

In certain examples, the microphone is a feedforward microphone arranged to be acoustically coupled to the air adjacent to the user's pinna for feedforward noise cancelation.

In some implementations, the hearing aid also includes a second microphone supported by the casing.

In certain implementations, the second microphone includes a microphone array.

In some cases, the hearing aid is incorporated into a system that also includes a computing device. The computing device is communicatively coupled to the hearing aid and configured to execute a software program that allows a user to adjust one or more features of the hearing aid.

In certain cases, the software program allows a user to adjust signal processing parameters of the hearing aid.

In some examples, the signal processing parameters include filter coefficients for the active noise cancellation algorithm.

Implementation may provide one or more of the following benefits.

Implementations may allow a device, such as an earpiece, to be designed with low occlusion and flat low frequency output that cannot unintentionally produce excessive low frequency pressures due to blocking of its acoustic ports. Some implementations may allow for greater consistency of an earpiece's output regardless of blocking of the ports. In the case of hearing assistance devices, certain implementations described herein may allow the device to be tested according to standardized testing without generating excessive pressures.

The details of one or more implementations are set forth in the accompanying drawings and the description below. Other features, objects and advantages will be apparent from the description and drawings, and from the claims.

### BRIEF DESCRIPTION OF THE DRAWINGS

FIG. 1 is perspective view of a typical receiver-in-canal (RIC) hearing aid.
FIG. 2A is a front view of a closed dome ear tip for a hearing aid.
FIG. 2B is a front view of an open dome ear tip for a hearing aid.
FIG. 3A is a perspective view of an earpiece from an exemplary RIC style hearing aid.
FIG. 3B is a schematic cross-sectional side view of the earpiece of FIG. 3A.
FIG. 4 is a plot showing a difference of sound pressure levels between sealed and unsealed front ports in an earpiece constructed according to FIG. 3A.
FIG. 5A is a schematic cross-sectional side view of another exemplary earpiece configured in accordance with this disclosure.
FIGS. 5B through 5D are schematic cross-sectional side views showing alternative implementations of earpieces configured in accordance with this disclosure.
FIG. 6 is a plot showing a difference of sound pressure levels between sealed and unsealed front ports in an earpiece constructed according to FIG. 5A.
FIG. 7 is a schematic view of an exemplary hearing aid configured in accordance with this disclosure.
FIG. 8A is a schematic view of an exemplary system configured in accordance with this disclosure.
FIG. 8B is a schematic view of an exemplary computing device from the system of FIG. 8A.
FIGS. 9, 10, 11A, and 11B are schematic cross-sectional side views showing alternative implementations of earpieces configured in accordance with this disclosure.
FIG. 12 is a schematic cross-sectional side view of an earcup configured in accordance with this disclosure.
FIG. 13 is a schematic view of a pair of headphones incorporating the earcup of FIG. 12.

It is noted that the drawings of the various implementations are not necessarily to scale. The drawings are intended to depict only typical aspects of the disclosure, and therefore should not be considered as limiting the scope of the invention. In the drawings, like numbering represents like elements between the drawings.

### DETAILED DESCRIPTION

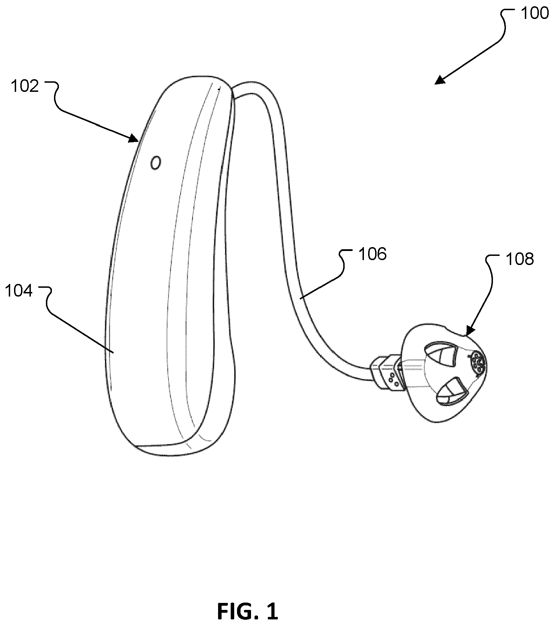

With reference to FIG. 1, a typical receiver-in-canal (RIC) hearing aid 100 includes a behind-the-ear portion 102 that includes a battery, a microphone, and a sound processor housed in a casing 104 designed to sit behind a user's ear (pinna). This behind-the-ear portion 102 of the hearing aid 100 has a small wire 106 designed to run around the user's ear and into an ear piece 108 that is designed to sit in the user's ear canal. The earpiece 108 carries a speaker, also known as the "receiver" or "driver."

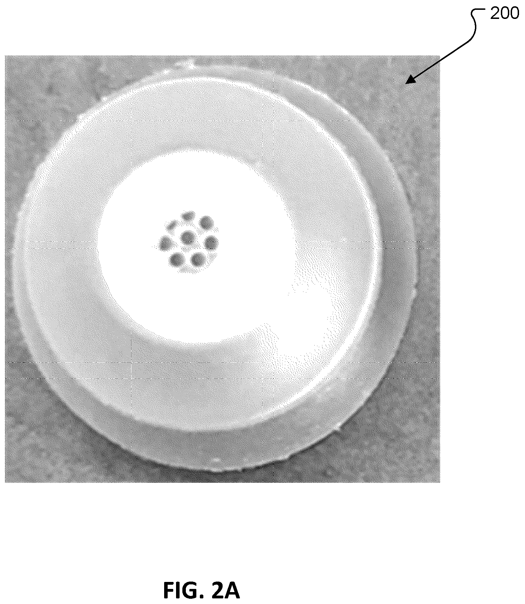

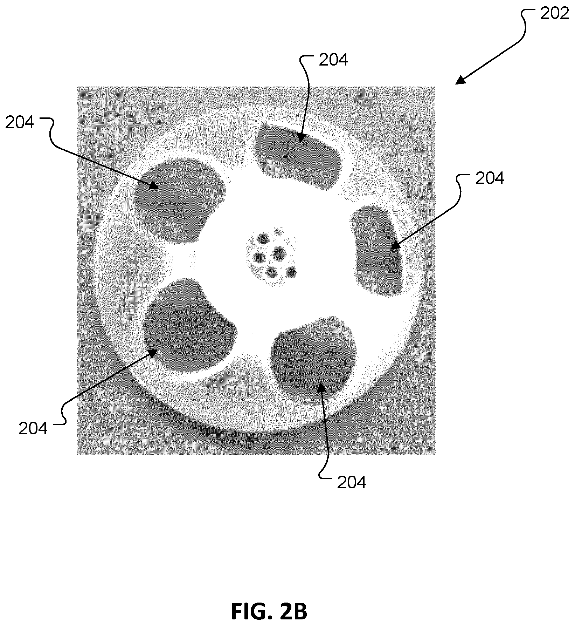

Conventional RIC style hearing aids often include a compliant tip on the ear piece for engaging the user's ear canal, which help to keep the ear piece in place within the user's ear canal. These ear tips, or "domes," are typically either i) closed - forming a tight acoustic seal with the user's ear canal (see "closed dome 200" of FIG. 2A); or ii) open - having a number of large apertures 204that allow acoustic energy to move into and out of the user's ear canal (see "open dome 202" of FIG. 2B).

The closed dome configuration suffers from what is known as the occlusion effect. The occlusion effect amplifies lower-frequency components of the user's own voice due to the acoustic blockage of the ear canal. Vibrations due to the user's voice travel through the head and into the ear canal. When the ear is not occluded, the associated pressure escapes out of the ear; when the ear is occluded, and the pressure cannot escape, low-frequency components are grossly amplified inside the user's ear. Occluding the ear causes an additional problem- blocking of the ear canal prevents higher frequency components of the user's voice from traveling around the head and back in the ear. These two issues result in undesirable own-voice quality, typically perceived as the user's voice being "boomy" or "muffled." By "own-voice," we refer to the user's perception of their own voice while speaking.

The open dome (a/k/a "low-occlusion") configuration relieves this occlusion effect, but it introduces another problem. Low-Occlusion in-ear devices typically have a leak path from the ear canal to outside the device and ear canal. This leak reduces product-generated low frequency pressures that can reach the ear. In order to get a flat response in such a configuration, the device must produce excess air compression at low frequencies relative to a more occluding device. For many potential configurations, this leak path can become plugged or sealed, for instance by poor fit, ear wax or foreign material. This can result in the device generating higher pressures in the ear canal than intended by design. These higher pressures may exceed regulatory or safety limits. This disclosure is based, at least in part, on the realization that an earpiece architecture can be designed such that these fault conditions result in smaller increases to the pressure potentially produced by the device.

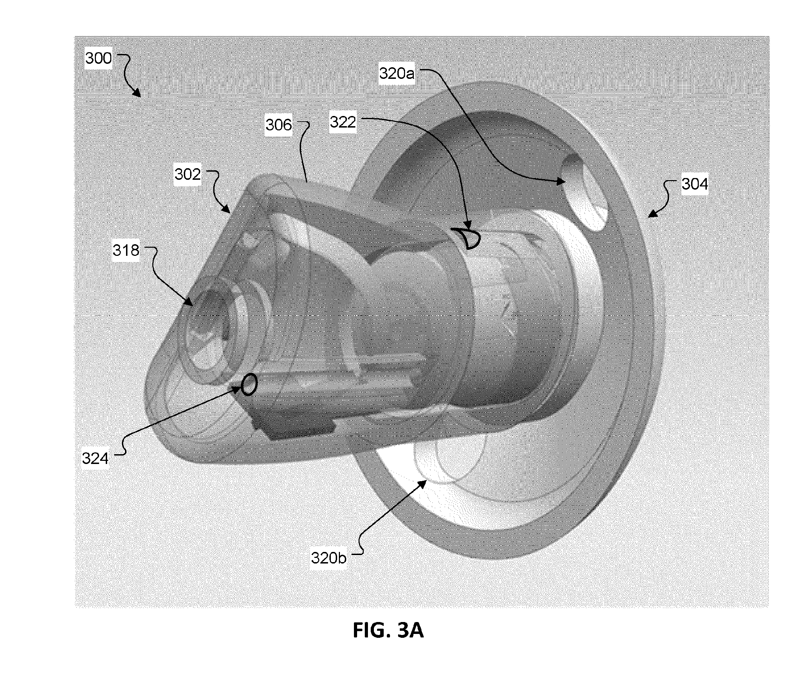

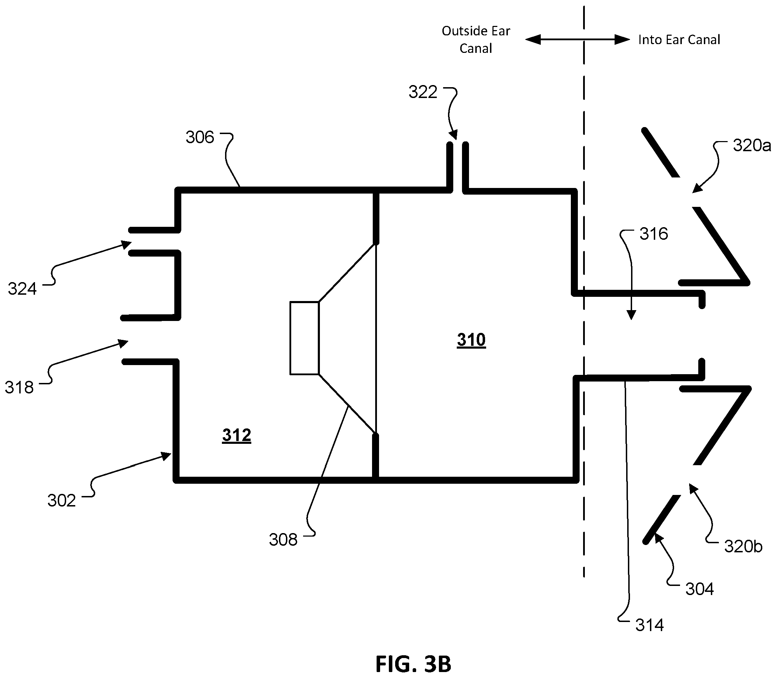

FIGS. 3A and 3B illustrate an exemplary earpiece 300 for a RIC style hearing aid. The earpiece 300 includes an earbud 302 and an ear tip 304. The earbud 302 includes a housing 306 that supports an electro-acoustic transducer 308 (a/k/a speaker or driver). Together, the housing 306 and the electro-acoustic transducer 308 define a first (front) acoustic volume 310 and a second (rear) acoustic volume 312. The electro-acoustic transducer 308 is arranged such that a first (front) radiating surface of the transducer 308 radiates acoustic energy into the front acoustic volume 310, and such that a second (rear) radiating surface of the transducer 308 radiates acoustic energy into the rear acoustic volume 312.

The housing 306 also defines a nozzle 314 that is configured to be coupled to the ear tip 304. The front acoustic volume 310 is acoustically coupled to an acoustic passage 316 in the nozzle 314, e.g., such that the electro-acoustic transducer 308 can be acoustically coupled to a user's ear canal when the earpiece 300 is worn. The housing 306 also defines a receptacle 318 for receiving wiring for powering the electro-acoustic transducer 308.

The ear tip 304 is supported on the nozzle 314 and includes a pair of front ports; i.e., first and second front ports 320a and 320b, respectively. The housing 306 also defines a third front port 322 that acoustically couples the front acoustic volume 310 to the area external to the housing 306. While three front ports are shown and described, there could be fewer or more ports. The port(s) may consist of an open hole, a screen covered hole, or any other configuration that results in a desired acoustic behavior. In some configurations, the third front port 322 proves a small acoustic leak, while the first and second front ports 320a, 320b provide relatively large acoustic leaks. The earpiece 300 also includes a rear port 324 that couples the rear acoustic volume 312 to the space outside the housing 306. The rear port 324 primarily serves to reduce the effective stiffness of the rear volume on the driver and prevent overpressure due to environmental changes, while the front port(s) 320a, 320b, 322 prevent excess low frequency pressures in the ear canal and reduce occlusion.

In the earpiece 300 illustrated in FIGS. 3A and 3B, if the first and second front ports 320a, 320b are sealed, e.g., by improper fit, wax, or foreign material, large pressures could be generated at the ear drum. Also note that some test procedures may dictate that these ports are sealed during testing. If a system has both large leak due to its front ports and large driver output to make up for this leak, doing so will show artificially high pressures during these tests.

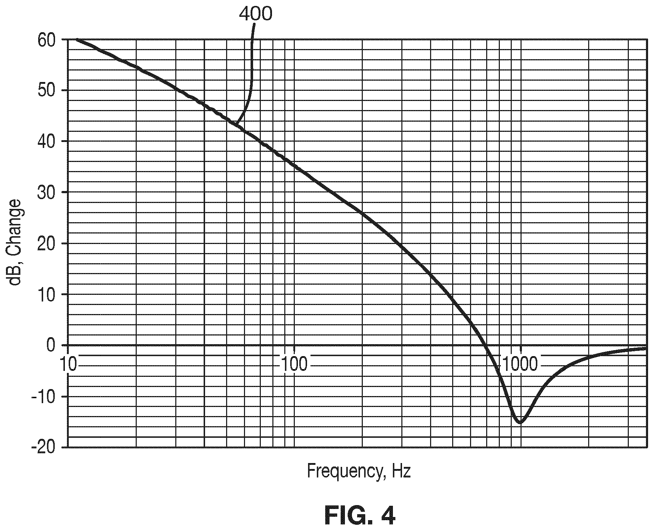

FIG. 4 shows an example comparison for sealed and unsealed front ports 320a, 320b, 322 in an earpiece constructed according to FIG. 3A. Curve 400 illustrates the difference in generated pressures per volt when the front ports 320a, 32b, 422 are sealed versus when the front ports 320a, 320b, 422 are open. As can be seen in FIG. 4, there is a significant increase in sound pressure level when the front ports 302a, 320b, and 322 are sealed particularly at frequencies below 700 Hz.

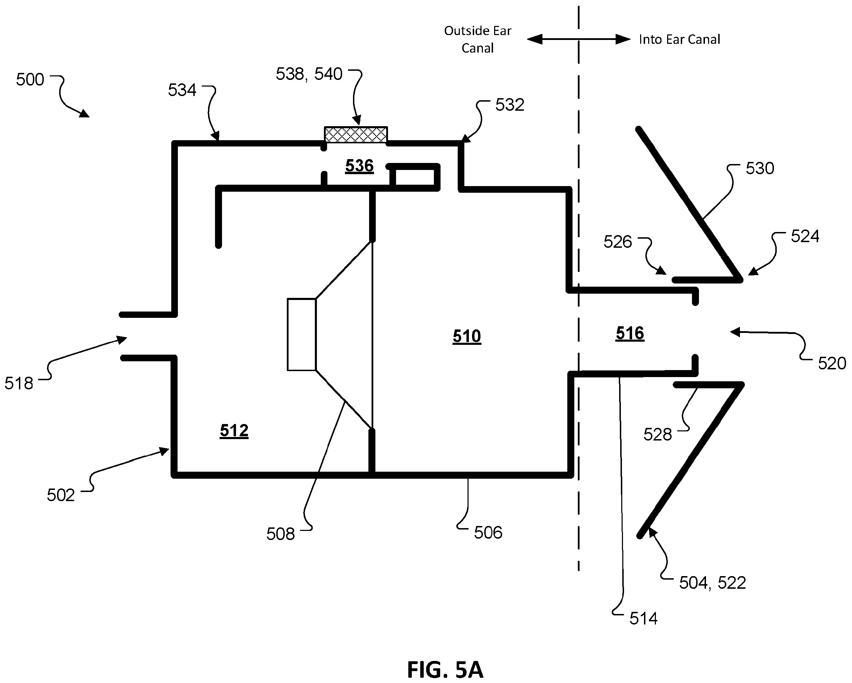

FIG. 5A shows another exemplary earpiece 500 constructed in accordance with this disclosure. One goal of the configuration illustrates in FIG. 5A is to help ensure that for any given blocking of the device's acoustic ports, the device performance change does not create potential to generate unintentionally high SPLs. A secondary benefit is that the proposed device would not create un-representatively high pressures during standardized testing.

The earpiece 500 includes an earbud 502 and an ear tip 504. The earbud 502 includes a housing 506 that supports an electro-acoustic transducer 508 (a/k/a speaker or driver). The electro-acoustic transducer 508 may be a moving coil transducer. The electro-acoustic transducer 508 may be a full range microdriver, e.g., having a diaphragm less than 6 mm in diameter, e.g., between 3 mm and 5.5 mm in diameter, e.g., 4.3 mm to 5.4 mm in diameter, such as those described in U.S. Pat. No. 9,942,662, titled "Electro-acoustic driver having compliant diaphragm with stiffening element," and issued on April 10, 2018, and/or U.S. Pat. No. 10,609,489, titled "Fabricating an integrated loudspeaker piston and suspension," issued on March 31, 2020. As used herein "full range" is intended to mean capable of producing frequencies from about 20 Hz to about 20 kHz.

Together, the housing 506 and the electro-acoustic transducer 508 define a first (front) acoustic volume 510 and a second (rear) acoustic volume 512. The electro-acoustic transducer 508 is arranged such that a first (front) radiating surface of the transducer 508 produces acoustic energy in the front acoustic volume 510, and such that a second (rear) radiating surface of the transducer 508 produces acoustic energy in the rear acoustic volume 512.

The housing 506 also defines a nozzle 514 that is configured to be coupled to the ear tip 504. The front acoustic volume 510 is acoustically coupled to an acoustic passage 516 in the nozzle 514, e.g., such that the electro-acoustic transducer 508 can be acoustically coupled to a user's ear canal when the earpiece 500 is worn. The housing 506 also defines a receptacle 518 for receiving wiring for powering the electro-acoustic transducer 508. The housing 506 may be formed of, e.g., molded form, a hard plastic such as Acrylonitrile Butadiene Styrene (ABS), Polycarbonate/ Acrylonitrile Butadiene Styrene (PCB/ABS), polyetherimide (PEI), or stereolithography (SLA) resin).

In the illustrated example, the ear tip 504 is in the shape of a hollow cylinder with a hollow passage 520 that is configured to receive the nozzle 514 of the earbud 502. The ear tip 504 is configured to fit at least partially within a person's ear canal. The ear tip 504 includes a body 522 that is configured to receive and/or be mounted onto the earbud 502. The body 522 includes a first end 524 and a second end 526 opposite the first end 524. The body 522 further includes inner wall 528 extending between the first end 524 and the second end 526. The inner wall 528 defines and surrounds the hollow passage 520 which can be configured to conduct sound waves. The body 522 also includes an outer wall 530 connected to the inner wall 528 at the first end 524. The outer wall 530 extends away from the inner wall 528 toward the second end 526. In the illustrated example, the outer wall 530 is dome-like in shape; however other shapes, such as frustoconical, are contemplated. Additionally, implementations where the ear tip is supported by the housing 506 without the inclusion of a nozzle 514 are contemplated. In the example illustrated in FIG. 5A, the ear tip 504 is of the closed type with no ports or apertures so that a tight acoustic seal is formed with the user's ear canal. In the example illustrated in FIG. 5A, the ear tip 504 is of the closed type with no ports or apertures so that a tight acoustic seal is formed with the user's ear canal.

While an ear tip 504 in the shape of a hollow cylinder has been shown and described, the ear tip 504 is not limited to any particular shape and other shapes are contemplated.

The body 522 can be made of any suitable soft, flexible materials, including, for example, silicone, polyurethane, polynorbornene (e.g., Norsorex^{®} material available from D-NOV GmbH of Vienna, Austria), thermoplastic elastomer (TPE), and/or fluoroelastomer. In some implementations, the inner wall 528 and the outer wall 530 can be formed of different materials, e.g., in an additive manufacturing or two-shot molding process. In some cases, the inner wall 528 may be formed of a higher durometer material, e.g., to ensure good coupling to the nozzle 514, and the outer wall 530 may be formed of a lower durometer material, e.g., for compliance (to ensure a good acoustic seal) and comfort. Alternatively, or additionally, one or more parts of the ear tip may be custom molded to fit an individual's ears from a substantially rigid material. Furthermore, some implementations may not include an ear tip. In such cases, one or more parts of the earbud may be custom molded, e.g., from a substantially rigid material, to fit an individual's ears.

The earpiece 500 includes a front port 532 coupling the front acoustic volume 510 to space outside the housing 506, and a rear port 534 that couples the rear acoustic volume 512 to the space outside the housing 506. The rear port 534 primarily serves to reduce the effective stiffness of the rear volume on the driver and prevent overpressure due to environmental changes, while the front port 532 prevents excess low frequency pressures in the ear canal and reduces occlusion.

In some examples, the front port may be implemented in the form of a tube. The front port tube may be formed integrally with the housing 306. Alternatively, or additionally, the front port tube may be made of metal, e.g., stainless steel. The front port tube may include a metal tube seated inside a wall of the front acoustic volume 310. The housing 306 may be made of plastic, and the front port tube may be heat-staked to the plastic. The tube may be substantially straight or may be curved along its length. As used herein "diameter" is intended to cover a diameter of a circle for a circular cross-section as well as an equivalent diameter for a non-circular cross-section, e.g., square, rectangular, or substantially semi-circular cross-sections. Alternatively, the front port may be in the form of a hole, e.g., an open hole or a mesh covered hole.

In some cases, the rear port 534 may be implemented in the form of a tube. The tube may be formed integrally with the housing 506. Alternatively, or additionally, the tube may be made of metal, e.g., stainless steel. The tube may include a metal tube seated inside a wall of the rear acoustic volume 512. The housing 506 may be made of plastic, and the tube may be heat-staked to the plastic. Alternatively, the rear port may be implemented in the form of a hole, e.g., an open hole or a screen covered hole. The tube may be substantially straight or may be curved along its length. As used herein "diameter" is intended to cover a diameter of a circle for a circular cross-section as well as an equivalent diameter for a non-circular cross-section, e.g., square, rectangular, or substantially semi-circular cross-sections

Notably, an inlet end of the front port 532 is internal to the earpiece 500 such that the only way to block it external to the earpiece 500 is to block the nozzle 514 of the earpiece 500. This can be desirable, since blocking the nozzle 514 may prevent any artificially high product-generated sound pressures from entering the ear. Also note that respective outlet ends of the rear port 534 and the front port 532 combine before exiting the product via a combined exit volume 536 and an exit port 538. This means that neither can be plugged without plugging the other. In a plugged condition, the exit port impedance will increase, which will acoustically short circuit the front and rear acoustic volumes 510, 512, reducing the pressure at the ear relative to that which would have occurred by plugging only the front port 532. This can be designed to also result in reduced maximum pressures. In some implementations, the maximum pressure in the front acoustic volume 510 when the exit port 538 is sealed (blocked) is between 100 dB SPL and 120 dB SPL. In some cases, the maximum pressure in the front acoustic volume 510 when the exit port 538 is sealed is no greater than 132 dB SPL.

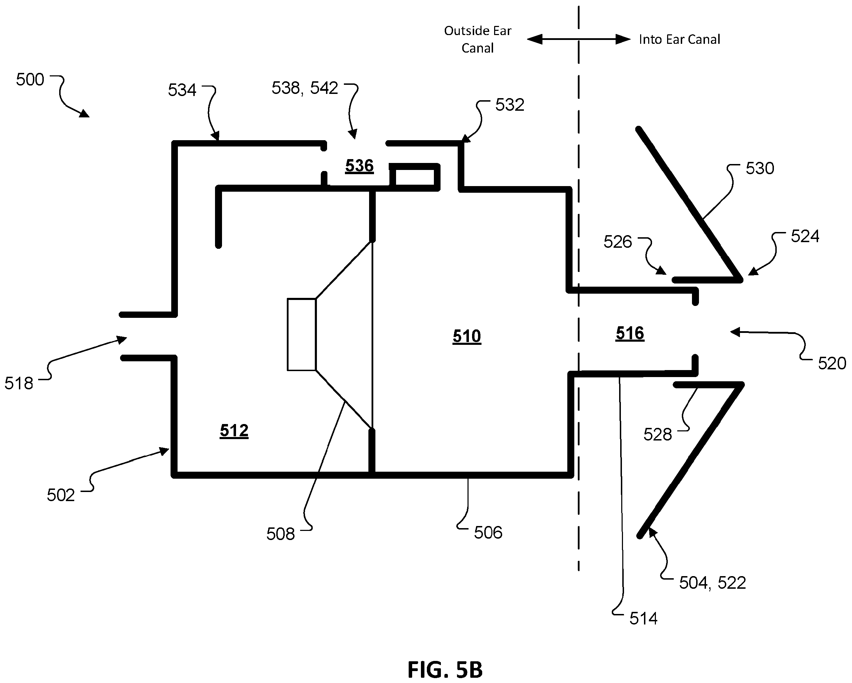

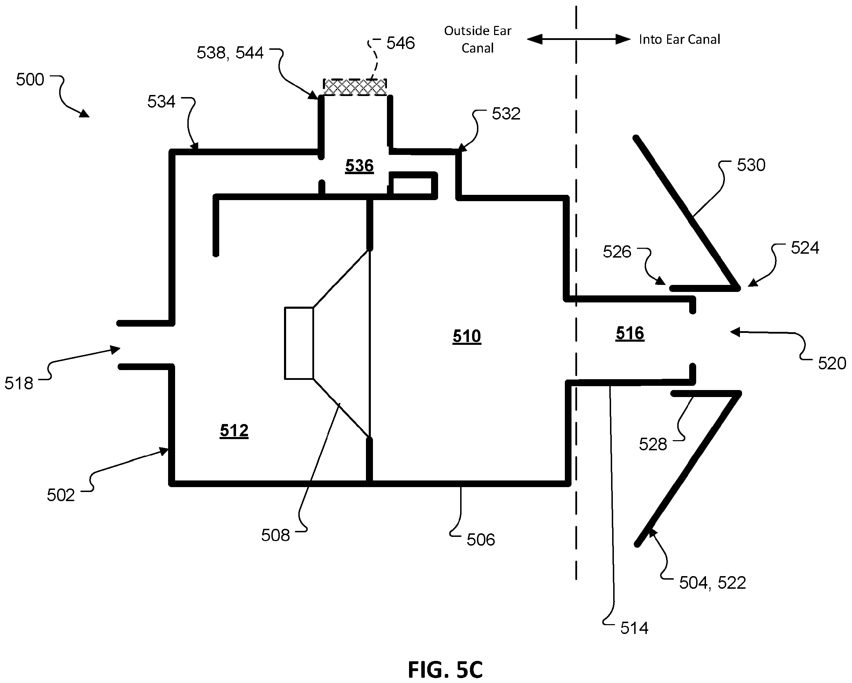

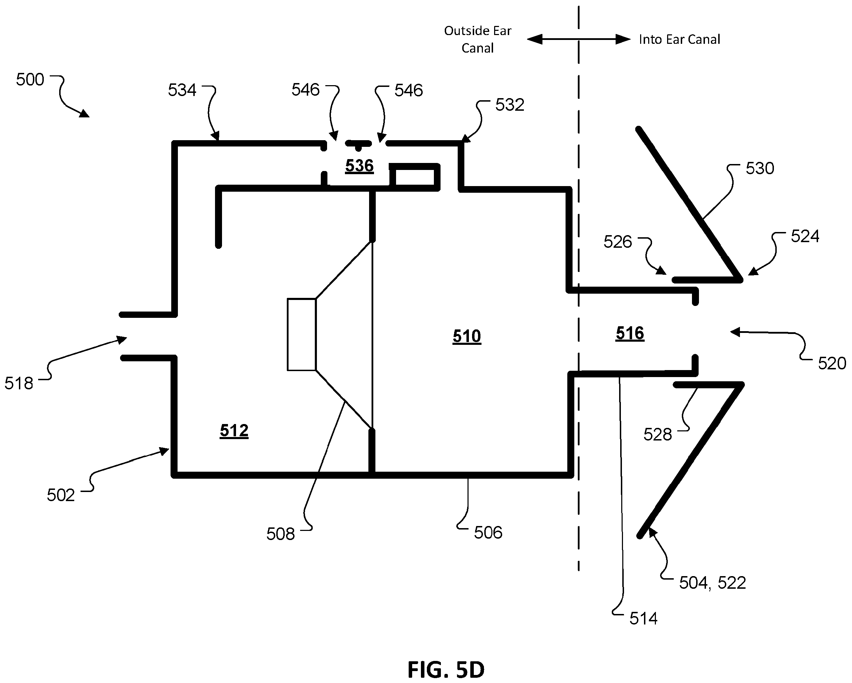

The exit port 538 may take various forms such as a mesh (e.g., metal screen) covered hole 540 (FIG. 5A), an open hole 542 (FIG. 5B), a tube 544 (FIG. 5C), or a plurality of holes, e.g., a plurality of mesh covered or open holes 546 (FIG. 5D). The outlet end of the tube 544 of FIG. 5C may or may not be covered with a mesh. The exit volume size and exit port impedance may be tuned to provide a desired performance under open and sealed conditions. Furthermore, while a single exit port is shown, the exit may include a multitude of openings.

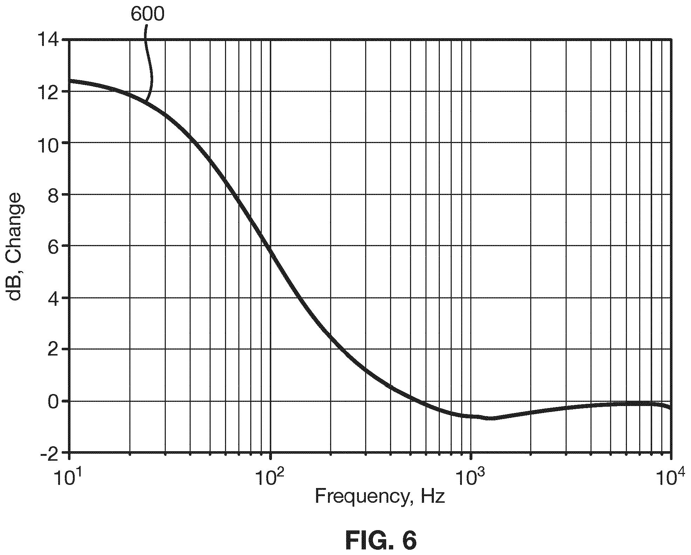

FIG. 6 shows an example comparison (difference curve) for a sealed and an unsealed exit port 538 in an earpiece constructed according to FIG. 5A. Curve 600 illustrates the difference in generated pressures per volt when the exit port 538 is sealed versus when the exit port 538 is open. Note the small difference between the sealed and unsealed cases, relative to that shown in FIG. 4.

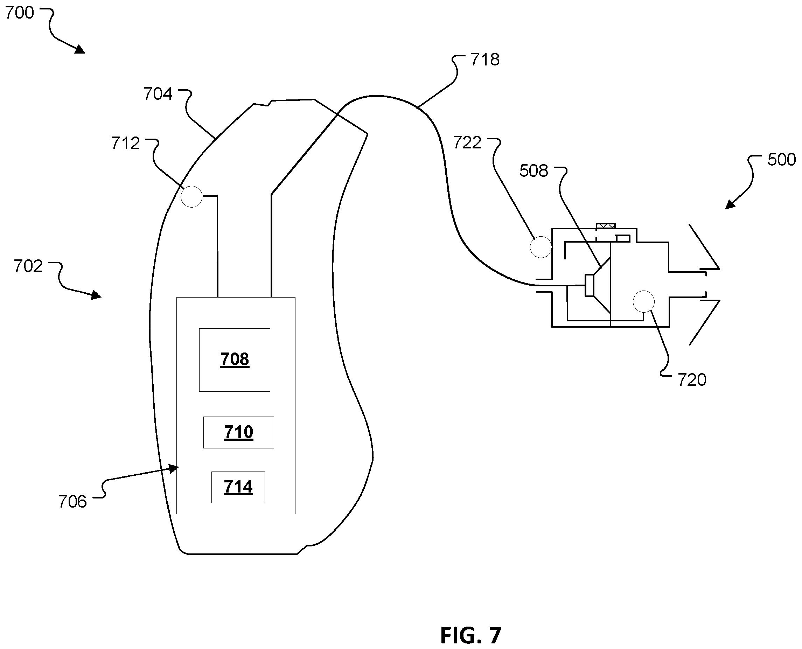

FIG. 7 illustrates an exemplary hearing aid 700 that includes the earpiece 500 of FIG. 5A and a behind-the-ear portion 702 designed to sit behind a user's ear (pinna). The behind-the-ear portion 702 includes a casing 704 that houses electronics 706 including a sound processor 708, a battery 710 for powering the electronics 708, and a microphone 712. In some cases, the microphone 712 may include a plurality of microphones that may be configured in an array. The sound processor 708 receives signals from the microphone 712 and performs one or more processing operations including beam steering, null forming, gain, compression, and/or active noise cancellation (e.g., feedforward active noise cancellation).

The electronics 706 may also include a transceiver circuit 714. The transceiver circuit 714 may transmit and receive wireless signals, including receive streaming audio (e.g., high fidelity audio) for rendering by the electro-acoustic transducer 508. The transceiver circuit 714 may communicate wirelessly with a data source such as a smartphone or any other suitable digital audio playing device, such as a laptop or personal computer, that stores and/or plays digital audio files. The transceiver circuit 714 may alternatively or additionally be configured to communicate with a second, companion hearing aid, e.g., for transmitting digital audio content between the two hearing aids, e.g., for stereo playback or beamforming. The transceiver circuit 714 may communicate, e.g., with the data source or a second, companion hearing aid, using any suitable wireless communication protocol, including Bluetooth, Bluetooth Low Energy (BLE), Wi-Fi (e.g., IEEE 802.11 alb/g/n), WiMAX (IEEE 802.16), Zigbee, UWB, NFMI, or any other suitable wireless communication protocol.

The transceiver circuit 714 may also enable communication with a software application running on a computing device, such as a smart phone. The software application may be used for self-tuning to allow a user to adjust DSP filters to tune audio (either high fidelity audio coming from an audio data source or audio delivered from the microphone 712 (e.g., a microphone array).

The electronics 706 may further include an audio amplifier, an analog-to-digital (A/D) converter, e.g., for converting an analog microphone signal to digital form, a digital-to-analog (D/A) converter, e.g., for converting a digital audio signal to analog form for transduction by the electro-acoustic transducer 508, and a microcontroller for controlling operation of the various electronic components.

This behind-the-ear portion 702 of the hearing aid 700 includes wiring 718 designed to run around the user's ear and into the earpiece 500. The wiring 718 may include a plurality of wires carried in a common conduit (e.g., a sheath or tube) that runs between the earpiece and the behind-the-ear portion. The wiring 718 powers the electro-acoustic transducer 508. The wiring 718 may also be used to couple the electronics 706 to a microphone 720 (e.g., a feedback microphone) supported in the housing 506 of the earpiece 500. The wiring 718 may include flexible printed circuitry; i.e., one or more flexible printed circuits and/or the wiring 718 may be coupled to one or more flexible printed circuits within the housing 506.

The microphone 720 is arranged for picking up audio at the user's ear canal. Input from the microphone 720 may be fed back to the sound processor 708 for feedback active noise cancelation. The microphone 720 may be supported by the electro-acoustic transducer 508 such as described in U.S. Pat. No. 10,015,581, titled "Feedback microphone adaptor for noise canceling headphone" and issued on July 3, 2018.

In some implementations, the hearing aid 700 may alternatively, or additionally, include a microphone 722 (e.g., a feedforward microphone) supported by (e.g., support on or within) the housing 506 of the earpiece 500 and arranged to be acoustically coupled to the air adjacent to the user's pinna. Input from the microphone 722 may be fed back to the sound processor 708 via the wiring 718 for feedforward active noise cancelation.

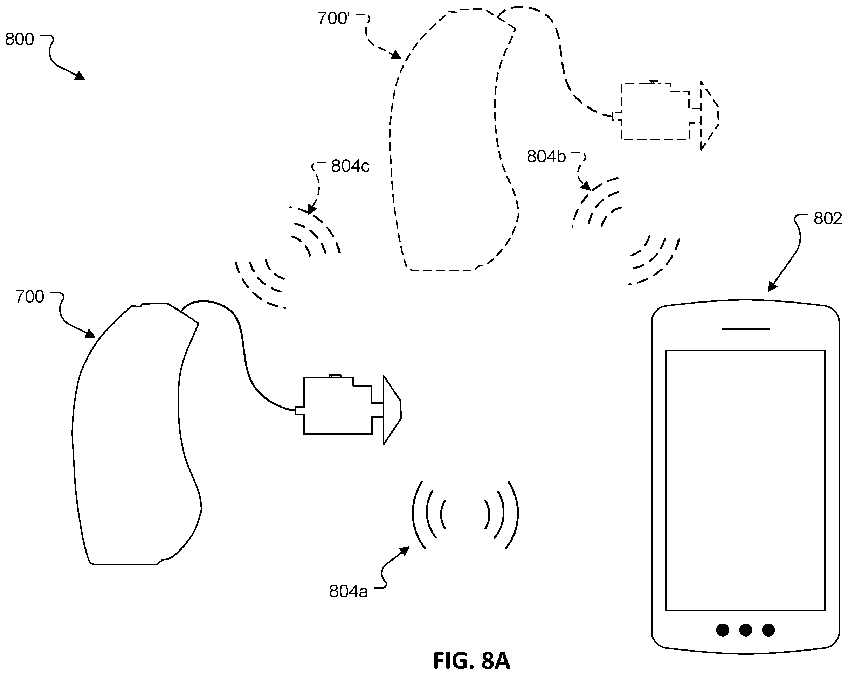

FIG. 8A show a system 800 including the hearing aid 700 of FIG. 7 and a computing device 802 (e.g., a smart phone). The hearing aid 700 and the computing device 802 may communicate wirelessly over a wireless network 804a via respective transceivers. As described above, the computing device 802 may be configured to provide audio to the hearing aid 700. The computing device 802 may also be used for selecting audio content for playback, transport control, e.g., play/pause, and/or volume or equalization control. In some implementations, the computing device 802 may execute a software program that allows a user to adjust signal processing parameters for the hearing aid, such as described in U.S. Pat. No. 9,131,321, titled "Hearing assistance device control," and issued on September 8, 2015.

In some cases, the system 800 may include a second, companion hearing aid 700'. The computing device 802 may be configured to communicated wirelessly with the second hearing aid 700' either directly (e.g., via a wireless network 804b) or via the (first) hearing aid 700. Furthermore, the hearing aids 700, 700' may be configured to communicate wirelessly with each other, e.g., for sharing audio data or control information over a wireless network 804c.

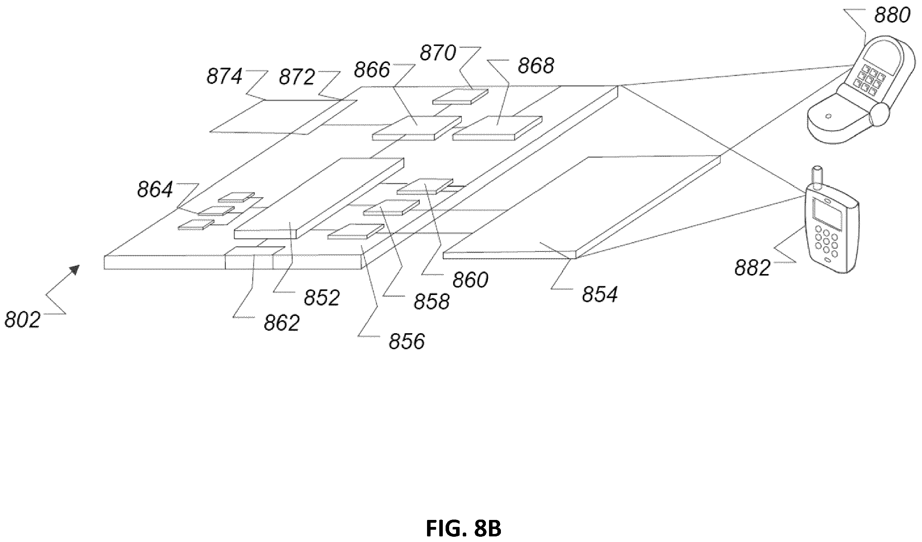

With reference to FIG. 8B, the computing device 802 includes a processor 852, memory 864, an input/output device such as a display 854, a communication interface 866, and a transceiver 868, among other components. The device 802 may also be provided with a storage device, such as a microdrive or other device, to provide additional storage. Each of the components 802, 852, 864, 854, 866, and 868, are interconnected using various buses, and several of the components may be mounted on a common motherboard or in other manners as appropriate.

The processor 852 can execute instructions within the computing device 802, including instructions stored in the memory 864. The processor may be implemented as a chipset of chips that include separate and multiple analog and digital processors. The processor may provide, for example, for coordination of the other components of the device 802, such as control of user interfaces, applications run by device 802, and wireless communication by device 802.

Processor 852 may communicate with a user through control interface 858 and display interface 856 coupled to a display 854. The display 854 may be, for example, a TFT LCD (Thin-Film-Transistor Liquid Crystal Display) or an OLED (Organic Light Emitting Diode) display, or other appropriate display technology. The display interface 856 may comprise appropriate circuitry for driving the display 854 to present graphical and other information to a user. The control interface 858 may receive commands from a user and convert them for submission to the processor 852. In addition, an external interface 862 may be in communication with processor 852, so as to enable near area communication of device 802 with other devices. External interface 862 may provide, for example, for wired communication in some implementations, or for wireless communication in other implementations, and multiple interfaces may also be used.

The memory 864 stores information within the computing device 802. The memory 864 can be implemented as one or more of a computer-readable medium or media, a volatile memory unit or units, or a non-volatile memory unit or units. Expansion memory 874 may also be provided and connected to device 802 through expansion interface 872, which may include, for example, a SIMM (Single In Line Memory Module) card interface. Such expansion memory 874 may provide extra storage space for device 802 or may also store applications or other information for device 802. Specifically, expansion memory 874 may include instructions to carry out or supplement the processes described above and may include secure information also. Thus, for example, expansion memory 874 may be provide as a security module for device 802 and may be programmed with instructions that permit secure use of device 802. In addition, secure applications may be provided via the SIMM cards, along with additional information, such as placing identifying information on the SIMM card in a non-hackable manner.

The memory may include, for example, flash memory and/or NVRAM memory, as discussed below. In one implementation, a computer program product is tangibly embodied in an information carrier. The computer program product contains instructions that, when executed, perform one or more methods, such as those described above. The information carrier is a computer- or machine-readable medium, such as the memory 864, expansion memory 874, memory on processor 852, or a propagated signal that may be received, for example, over transceiver 868 or external interface 862.

Device 802 may communicate wirelessly through communication interface 866, which may include digital signal processing circuitry where necessary. Communication interface 866 may provide for communications under various modes or protocols, such as GSM voice calls, SMS, EMS, or MMS messaging, CDMA, TDMA, PDC, WCDMA, CDMA2000, or GPRS, among others. Such communication may occur, for example, through radio-frequency transceiver 868. In addition, short-range communication may occur, such as using a Bluetooth, WiFi, or other such transceiver (not shown). In addition, GPS (Global Positioning System) receiver module 870 may provide additional navigation- and location-related wireless data to device 802, which may be used as appropriate by applications running on device 802.

Device 802 may also communicate audibly using audio codec 860, which may receive spoken information from a user and convert it to usable digital information. Audio codec 860 may likewise generate audible sound for a user, such as through a speaker, e.g., in a handset of device 802. Such sound may include sound from voice telephone calls, may include recorded sound (e.g., voice messages, music files, and so forth) and may also include sound generated by applications operating on device 802.

The computing device 802 may be implemented in a number of different forms, as shown in the figure. For example, it may be implemented as a cellular telephone 880. It may also be implemented as part of a smartphone 882, personal digital assistant, tablet computer, or other similar mobile device.

### Other Implementations

In the example described above, with respect to FIG. 5A, the ear tip 504 is of the closed type with no ports or apertures so that a tight acoustic seal is formed with the user's ear canal. However, in some implementations, the ear tip may include pressure equalization ports or apertures provided that any ports in the ear tip are much smaller than the pressure equalization port in the housing.

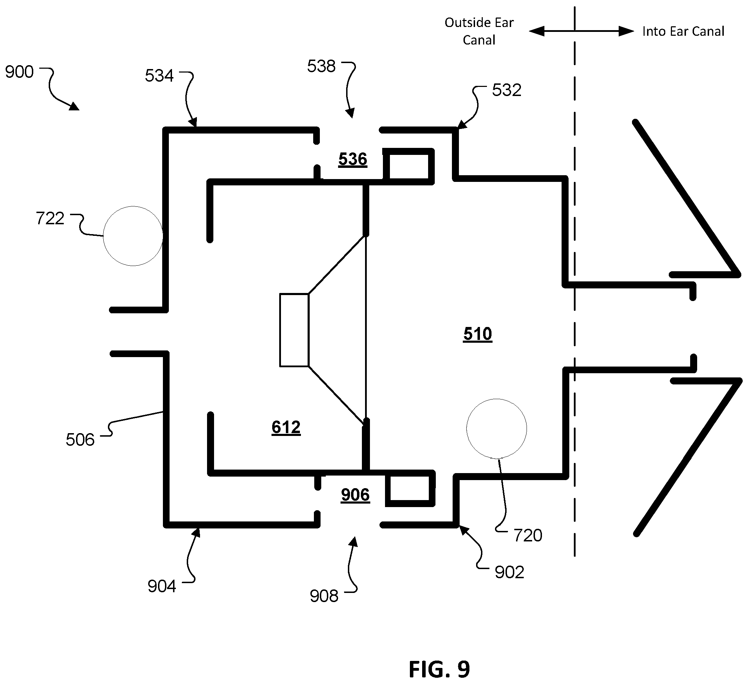

While implementations have been described that include a single rear port and a single front port that are coupled to a common exit port, some implementations may include plural pairs of rear ports and front ports, e.g., with each pair coupled to a corresponding exit port. For example, FIG. 9 illustrates an earpiece 900 that includes a first front port 532 and a first rear port 534 whose outlets are combined in a first exit volume 536 before exiting the earpiece 900 via a first exit port 538, as well as a second front port 902 and a second rear port 904 whose outlets are combined in a second exit volume 906 before exiting the earpiece 900 via a second exit port 908. The front ports 532, 902 acoustically couple the front acoustic volume 510 to the area external to the housing 506 and the rear ports 534, 904 acoustically couple the rear acoustic volume 512 to the area external to the housing 506. As in the implementations described above, the exit ports 538, 908 may or may not be covered with a mesh and may or may not include a tube(s). The use of plural exit ports may reduce the likelihood of a complete seal, but still helps to mitigate pressure increases if either one or both of the exit ports are sealed. It is also possible to have multiple front ports and/or multiple rear ports combining into the same exit volume. Where multiple port paths are used, they may be either identical or different in dimension/acoustic impedance.

The earpiece 900 may also include a microphone 720 (e.g., a feedback microphone) acoustically coupled to the first acoustic volume 510 for picking up audio in the user's ear canal. The earpiece 900 may alternatively, or additionally, include a microphone 722 (e.g., a feedforward microphone) supported by the housing 506 of the earpiece 500 for picking up ambient noise for feedforward noise cancellation.

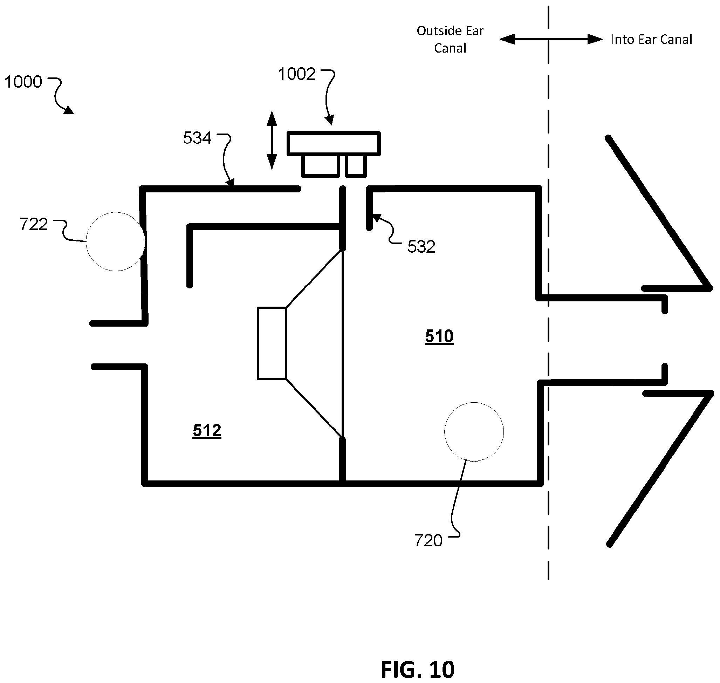

With reference to FIG. 10, in another implementation, an earpiece 1000 could be made by eliminating the exit volume and having a valve 1002 over the front port 532 and the rear port 534, such that if the valve 1002 closes, it closes off the front port 532 and the rear port 534 separately. In this case, the front and rear acoustic volumes 510, 512 would not acoustically short circuit. Instead, sealing of the mass port 534 would increase the stiffness of the system such that the acoustic pressure in the ear or in a 2 cm^3 coupler would be reduced relative to the sealed case shown in FIG. 4, but not as much as in the sealed case shown in FIG. 6. The earpiece 1000 may include a microphone 720 (e.g., a feedback microphone) acoustically coupled to the first acoustic volume 510 for picking up audio in the user's ear canal. The earpiece 1000 may alternatively, or additionally, include a microphone 722 (e.g., a feedforward microphone) supported by the housing 506 of the earpiece 500 for picking up ambient noise for feedforward noise cancellation.

While implementations have been described which use a moving coil type electro-acoustic transducer, some implementations may utilize a balanced armature driver. For example, some implementations may utilize a vented balanced armature driver that delivers acoustic output radiated from a first side of a diaphragm through a nozzle coupled to a first acoustic volume of an earpiece, and vents acoustic energy radiated from a second side of the diaphragm into a second acoustic volume of the earpiece.

Some implementations may include multiple balanced armatures. One example includes two (2) counterbalanced balanced armatures in a single housing, with two diaphragms. Respective front sides of the diaphragms combine internal to the housing and are acoustically coupled via an opening or nozzle to the front acoustic volume. The rear sides of the diaphragms are separated in the housing and vent separately into the rear acoustic volume.

Although implementations of earpieces for RIC style hearing aids have been shown and described above, the coupling of rear and front ports may be beneficial to other applications including earpieces for: in-ear hearing aids, e.g., completely-in-the-canal (CIC), in-the-canal (ITC), or in-the-ear (ITE) style hearing aids; and headphones, e.g., wired or wireless headphones, and in-ear or around-ear headphone styles.

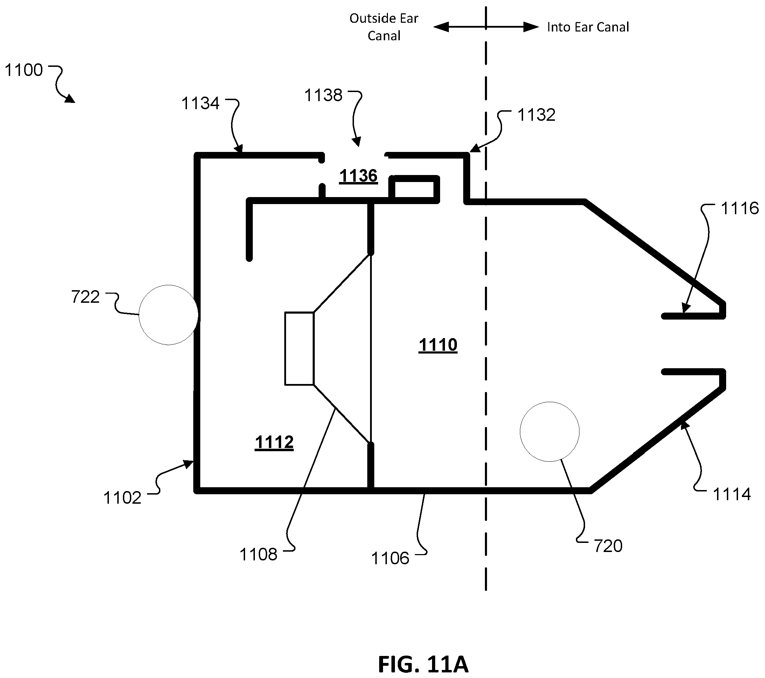

Furthermore, while implementations have been described in which an earpiece includes an earbud and an ear tip coupled to the earbud, FIG. 11A illustrates another implementation of an earpiece 1100 that includes an earbud 1102 without an ear tip. The earbud 1102 is configured to engage a user's ear canal directly to form an acoustic seal therebetween. The earbud 1102 includes a housing 1106 that supports an electro-acoustic transducer 1108 (a/k/a speaker or driver). Together, the housing 1106 and the electro-acoustic transducer 1108 define a first (front) acoustic volume 1110 and a second (rear) acoustic volume 1112. The electro-acoustic transducer 1108 is arranged such that a first (front) radiating surface of the transducer 1108 radiates acoustic energy into the front acoustic volume 1110, and such that a second (rear) radiating surface of the transducer 1108 radiates acoustic energy into the rear acoustic volume 1112.

The housing 1106 also defines a nozzle 1114 that is configured to engage a user's ear canal directly to form an acoustic seal therebetween. The front acoustic volume 1110 is acoustically coupled to an acoustic passage 1116 in the nozzle 1114, e.g., such that the electro-acoustic transducer 1108 can be acoustically coupled to a user's ear canal when the earpiece 1100 is worn. The housing 1106 may also define a receptacle (not shown) for receiving wiring for powering the electro-acoustic transducer 1108. In some cases, the housing 1106 may also support a microphone, a battery, and/or a sound processor.

The earpiece 1100 includes a front port 1132 coupling the front acoustic volume 1110 to the space outside the housing 1106, and a rear port 1134 that couples the rear acoustic volume 1112 to the space outside the housing 1106. As in the implementation discussed above with respect to FIG. 5A, respective outlet ends of the rear port 1134 and the front port 1132 combine before exiting the product via a combined exit volume 1136 and an exit port 1138. The exit port 1138 may take various forms such as a tube, a mesh, or a hole. The earpiece 1100 may include a microphone 720 (e.g., a feedback microphone) acoustically coupled to the first acoustic volume 510 for picking up audio in the user's ear canal. The earpiece 1000 may alternatively, or additionally, include a microphone 722 (e.g., a feedforward microphone) supported by the housing 506 of the earpiece 500 for picking up ambient noise for feedforward noise cancellation.

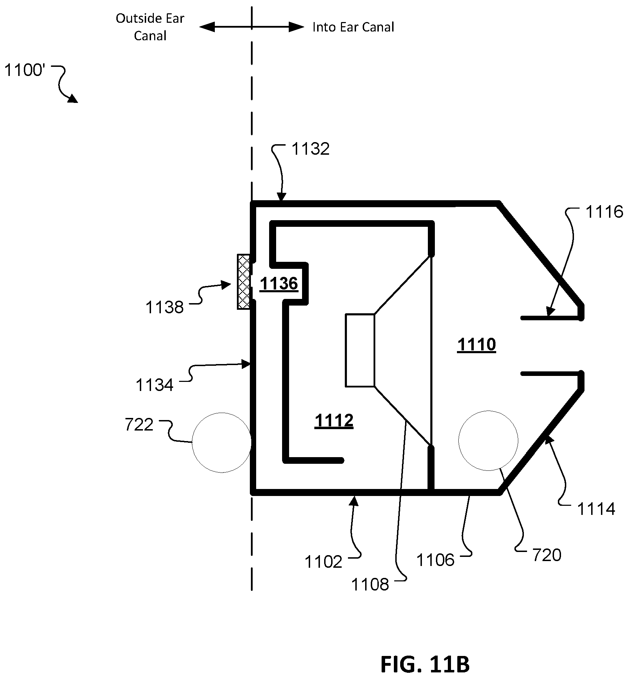

FIG. 11A illustrates a configuration that may be useful for an in-the-ear type hearing aid, FIG. 11B illustrates an alternative arrangement of an earpiece 1100' that may be beneficial for an in-the-canal or completely-in-canal configuration. In that regard, the configuration of FIG. 11B relocates the exit port 1138 from a surface of the housing 1106 adjacent the nozzle 1114 (as shown in FIG. 11A) to a surface of housing 1106 that is opposite the nozzle 1114.

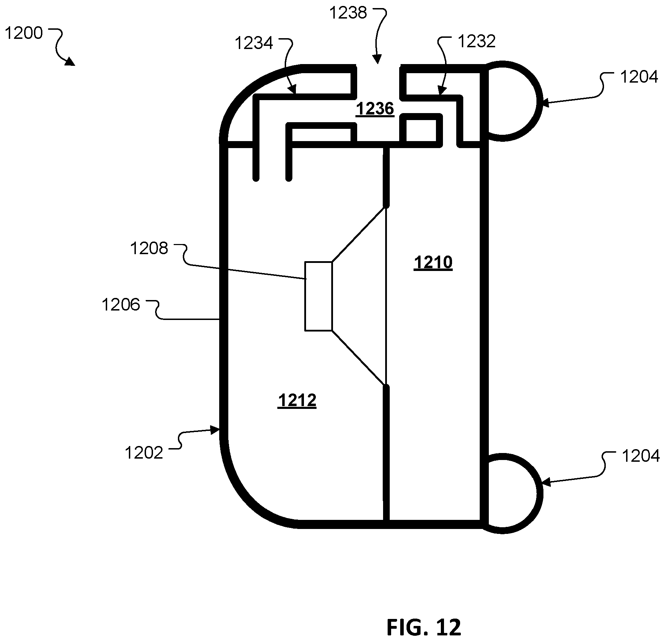

FIG. 12 illustrates an earpiece 1200 for an around-ear headphone. The earpiece 1200 includes an ear cup 1202 and a circumaural cushion 1204. The ear cup 1202 includes a housing 1206 that supports an electro-acoustic transducer 1208 (a/k/a speaker or driver). Together, the housing 1206 and the electro-acoustic transducer 1208 define a first (front) acoustic volume 1210 and a second (rear) acoustic volume 1212. The electro-acoustic transducer 1208 is arranged such that a first (front) radiating surface of the transducer 1208 radiates acoustic energy into the front acoustic volume 1210, and such that a second (rear) radiating surface of the transducer 1208 radiates acoustic energy into the rear acoustic volume 1212. The housing 1206 may be formed of a rigid material, such as plastic, e.g., ABS plastic. The circumaural cushion 1204 is configured to circumferentially surround a user's ear and to provide an acoustic seal between the front acoustic volume 1210 and the user's head when the device is worn. The circumaural cushion 1204 may be formed of a foam.

The earpiece 1200 includes a front port 1232 coupling the front acoustic volume 1210 to space outside the housing 1206, and a rear port 1234 that couples the rear acoustic volume 1212 to the space outside the housing 1206. As in the implementations described above, respective outlet ends of the rear port 1234 and the front port 1232 may be combined together before exiting the product via a combined exit volume 1236 and an exit port 1238.

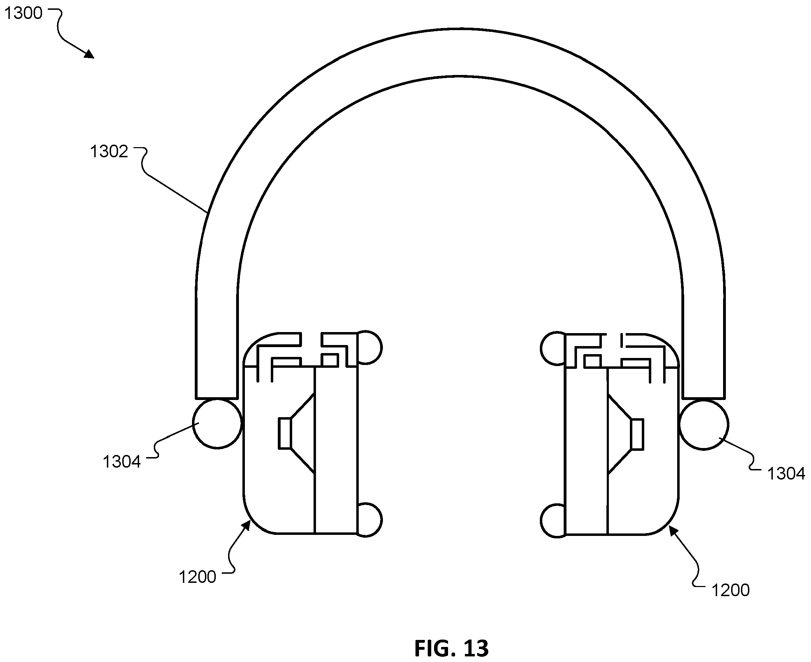

FIG. 13 illustrates an exemplary pair of headphones 1300 that incorporates the ear cup 1200 of FIG. 12. The headphones 1300 include a pair of earpieces 1200, constructed in accordance with FIG. 12, and a band 1302 that mechanically couples the two earpieces 1200 together. The ear cups 1200 (two shown) may be coupled to the band via yokes 1304 that allow for articulation of the earpieces 1200 relative the band 1302.

A number of implementations have been described. Nevertheless, it will be understood that additional modifications may be made without departing from the scope of the inventive concepts described herein, and, accordingly, other implementations are within the scope of the following claims.

While various examples have been described and illustrated herein, those of ordinary skill in the art will readily envision a variety of other means and/or structures for performing the function and/or obtaining the results and/or one or more of the advantages described herein, and each of such variations and/or modifications is deemed to be within the scope of the examples described herein. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings is/are used. Those skilled in the art will recognize, or be able to ascertain, using no more than routine experimentation, many equivalents to the specific examples described herein. It is, therefore, to be understood that the foregoing examples are presented by way of example only and that, within the scope of the appended claims and equivalents thereto, examples may be practiced otherwise than as specifically described. Examples of the present disclosure are directed to each individual feature, system, article, material, kit, and/or method described herein.

### EMBODIMENTS:

1. An earpiece comprising:
   an electro-acoustic transducer;
   a housing supporting the electro-acoustic transducer such that the housing and the electro-acoustic transducer together define a first acoustic volume and a second acoustic volume, the electro-acoustic transducer being arranged such that a first radiating surface of the transducer radiates acoustic energy into the front acoustic volume and such that a second radiating surface of the transducer radiates acoustic energy into the second acoustic volume;
   a front port coupling the first acoustic volume to a space outside the housing; and
   a rear port coupling the second acoustic volume to the space outside the housing,
   wherein respective outlet ends of the rear port and the front port combine before exiting the housing via a combined exit volume and an exit port.
2. The earpiece of embodiment 1, wherein the housing defines a nozzle, and wherein the first acoustic volume is acoustically coupled to an acoustic passage in the nozzle such that the electro-acoustic transducer is acoustically coupled to a user's ear canal when the earpiece is worn.
3. The earpiece of embodiment 2, further comprising an ear tip supported on the nozzle and configured to form a tight acoustic seal with a user's ear canal when the earpiece is worn.
4. The earpiece of embodiment 1, wherein the housing includes a receptacle for receiving wiring for powering the electro-acoustic transducer.
5. The earpiece of embodiment 1, wherein the exit port is covered with a mesh along an exterior surface of the housing.
6. The earpiece of embodiment 1, wherein the exit port comprises a tube.
7. The earpiece of embodiment 6, wherein an outlet end of the tube is covered with a mesh.
8. The earpiece of embodiment 1, wherein the front port is formed integrally with the housing.
9. The earpiece of embodiment 1, wherein a maximum pressure in the first acoustic volume when the exit port is sealed is between 100 dB SPL and 120 dB SPL.
10. The earpiece of embodiment 1, wherein a maximum pressure in the first acoustic volume when the exit port is sealed is no greater than 132 dB SPL.
11. A hearing aid comprising the earpiece of embodiment 1, the hearing aid further comprising:
   a casing configured to sit behind a user's pinna when worn; and
   wiring coupling the casing to the earpiece.
12. The hearing aid of embodiment 11, further comprising: a battery, a microphone, and a sound processor housed in the casing.
13. The hearing aid of embodiment 11, further comprising:
   electronics housed within the casing; and
   a microphone supported by the housing,
   wherein the wiring electrically couples the microphone to the electronics.
14. The hearing aid of embodiment 13, wherein the wiring comprises flexible printed circuitry.
15. The hearing aid of embodiment 13, wherein the wiring electrically couples the electro-acoustic transducer to the electronics.
16. The hearing aid of embodiment 13, wherein the microphone is a feedback microphone arranged for picking up audio at the user's ear canal.
17. The hearing aid of embodiment 13, wherein the microphone is a feedforward microphone arranged for picking up ambient noise in a region external to the housing for feedforward noise cancelation.
18. The hearing aid of embodiment 13, wherein the electronics are configured to execute an active noise cancellation algorithm that uses input from the microphone.
19. The hearing aid of embodiment 11, further comprising: a battery, a microphone, and a sound processor supported in the housing.
20. The hearing aid of embodiment 11, wherein the electro-acoustic transducer comprises a diaphragm defining the first and second radiating surfaces, and wherein the diaphragm has a diameter of less than 6 mm.
21. The hearing aid of embodiment 20, wherein the electro-acoustic transducer is a moving coil transducer.
22. The hearing aid of embodiment 11, further comprising:
   a battery;
   a first microphone;
   a sound processor;
   a transceiver;
   a second microphone; and
   wiring,
   wherein the battery, the first microphone, the sound processor, and the transceiver are housed in the casing,
   wherein the second microphone is supported by the housing; and
   wherein the wiring extends between the housing and the casing and electrically couples the second microphone to the sound processor.
23. The hearing aid of embodiment 11, wherein the sound processor is configured to execute an active noise cancellation algorithm that uses input from the second microphone.
24. An earpiece comprising:
   an electro-acoustic transducer;
   a housing supporting the electro-acoustic transducer, the housing and the electro-acoustic transducer together defining a first acoustic volume and a second acoustic volume, the electro-acoustic transducer being arranged such that a first radiating surface of the transducer radiates acoustic energy into the front acoustic volume, and such that a second radiating surface of the transducer radiates acoustic energy into the rear acoustic volume;
   a front port coupling the first acoustic volume to space outside the housing;
   a rear port coupling the second acoustic volume to the space outside the housing; and
   a valve over the front port and the rear port and arranged such that if the valve closes, it closes off the front port and the rear port separately.
25. A hearing aid comprising:
   an electro-acoustic transducer;
   a microphone;
   a housing supporting the electro-acoustic transducer and the microphone and sized to sit at least partially within a user's ear canal;
   electronics;
   a casing supporting the electronics and configured to sit behind a user's pinna when worn; and
   wiring extending between the casing to the housing and electrically coupling the electronics to the electro-acoustic transducer and the microphone.
26. The hearing aid of embodiment 25, wherein the electronics are configured to execute an active noise cancellation algorithm to produce a signal that causes the electro-acoustic transducer to produce acoustic energy to cancel noise based on input from the microphone.
27. A hearing aid comprising:
   an electro-acoustic transducer;
   a housing supporting the electro-acoustic transducer and sized to sit at least partially with in a user's ear canal;
   electronics;
   a casing supporting the electronics and configured to sit behind a user's pinna when worn;
   wiring extending between the casing to the housing and electrically coupling the electronics to the electro-acoustic transducer; and
   a microphone supported by the housing, wherein the electronics are configured to execute an active noise cancellation algorithm to produce a signal that causes the electro-acoustic transducer to produce acoustic energy to cancel noise based on input from the microphone.
28. The hearing aid of embodiment 27, wherein the electro-acoustic transducer is a full range transducer.
29. The hearing aid of embodiment 28, wherein the electro-acoustic transducer is a moving coil transducer.
30. The hearing aid of embodiment 27, wherein the electronics include a transceiver that supports transmission of high-fidelity audio.
31. The hearing aid of embodiment 27, wherein the microphone is supported by the housing and wherein the wiring electrically couples the microphone to the electronics.
32. The hearing aid of embodiment 31, wherein the microphone is a feedback microphone arranged for picking up audio at the user's ear canal.
33. The hearing aid of embodiment 31, wherein the microphone is a feedforward microphone arranged to be acoustically coupled to the air adjacent to the user's pinna for feedforward noise cancelation.
34. The hearing aid of embodiment 33, further comprising a second microphone supported by the casing.
35. The hearing aid of embodiment 34, wherein the second microphone comprises a microphone array.
36. A system comprising:
   the hearing aid of embodiment 27; and
   a computing device communicatively coupled to the hearing aid and configured to execute a software program that allows a user to adjust one or more features of the hearing aid.
37. The system of embodiment 36, wherein the software program allows a user to adjust signal processing parameters of the hearing aid.
38. The system of embodiment 37, wherein the signal processing parameters include filter coefficients for the active noise cancellation algorithm.

## Claims

1. A hearing aid (100, 700) comprising:
an electro-acoustic transducer (308, 508, 1108, 1208);
a housing (306, 506, 1106, 1206) supporting the electro-acoustic transducer and sized to sit at least partially with in a user's ear canal;
electronics (706);
a casing (104, 704) supporting the electronics and configured to sit behind a user's pinna when worn;
wiring (718) extending between the casing to the housing and electrically coupling the electronics to the electro-acoustic transducer;
a microphone (720, 722) supported by the housing, wherein the electronics are configured to execute an active noise cancellation algorithm to produce a signal that causes the electro-acoustic transducer to produce acoustic energy to cancel noise based on input from the microphone,
the hearing aid further comprising an earpiece (300, 500, 900, 1100, 1200), the earpiece comprising:
the electro-acoustic transducer;
the housing supporting the electro-acoustic transducer such that the housing and the electro-acoustic transducer together define a first acoustic volume (310, 510, 1110, 1210) and a second acoustic volume (312, 512, 1112, 1212), the electro-acoustic transducer being arranged such that a first radiating surface of the transducer radiates acoustic energy into the first acoustic volume and such that a second radiating surface of the transducer radiates acoustic energy into the second acoustic volume;
a front port (532, 1132, 1232) coupling the first acoustic volume to a space outside the housing; and
a rear port (534, 1134, 1234) coupling the second acoustic volume to the space outside the housing,
wherein respective outlet ends of the rear port and the front port combine before exiting the housing via a combined exit volume (536, 1136, 1236) and an exit port (538, 1138, 1238).

2. The hearing aid (100, 700) of claim 1, wherein the electro-acoustic transducer is a full range transducer.

3. The hearing aid (100, 700) of claim 2, wherein the electro-acoustic transducer is a moving coil transducer.

4. The hearing aid (100, 700) of claim 1, wherein the electronics include a transceiver that supports transmission of high-fidelity audio.

5. The hearing aid (100, 700) of claim 1, wherein the microphone is supported by the housing and wherein the wiring electrically couples the microphone to the electronics.

6. The hearing aid (100, 700) of claim 5, wherein the microphone is a feedback microphone arranged for picking up audio at the user's ear canal.

7. The hearing aid (100, 700) of claim 5, wherein the microphone is a feedforward microphone arranged to be acoustically coupled to the air adjacent to the user's pinna for feedforward noise cancelation.

8. The hearing aid (100, 700) of claim 7, further comprising a second microphone supported by the casing.

9. The hearing aid (100, 700) of claim 8, wherein the second microphone comprises a microphone array.

10. A system (800) comprising:
the hearing aid (700) of any one of the foregoing claims; and
a computing device (802) communicatively coupled to the hearing aid and configured to execute a software program that allows a user to adjust one or more features of the hearing aid.

11. The system of claim 10, wherein the software program allows a user to adjust signal processing parameters of the hearing aid.

12. The system of claim 11, wherein the signal processing parameters include filter coefficients for the active noise cancellation algorithm.

## Patentansprüche

1. Hörgerät (100, 700), umfassend:
einen elektroakustischen Wandler (308, 508, 1108, 1208);
ein Gehäuse (306, 506, 1106, 1206), das den elektroakustischen Wandler trägt und so dimensioniert ist, dass es zumindest teilweise im Gehörgang eines Benutzers sitzt;
Elektronik (706);
eine Außenhülle (104, 704), die die Elektronik trägt und so konfiguriert ist, dass es hinter der Ohrmuschel eines Benutzers sitzt, wenn es getragen wird;
Verkabelung (718), die sich zwischen der Außenhülle und dem Gehäuse erstreckt und die Elektronik elektrisch mit dem elektroakustischen Wandler koppelt;
ein Mikrofon (720, 722), das vom Gehäuse getragen wird, wobei die Elektronik so konfiguriert ist, dass sie einen aktiven Geräuschunterdrückungsalgorithmus ausführt, um ein Signal zu erzeugen, das den elektroakustischen Wandler dazu veranlasst, akustische Energie zu erzeugen, um Geräusche basierend auf dem Eingang vom Mikrofon zu unterdrücken,
wobei das Hörgerät ferner ein Ohrstück (300, 500, 900, 1100, 1200) umfasst, wobei das Ohrstück Folgendes umfasst:
den elektroakustischen Wandler;
das Gehäuse, das den elektroakustischen Wandler derart trägt, dass das Gehäuse und der elektroakustische Wandler zusammen ein erstes akustisches Volumen (310, 510, 1110, 1210) und ein zweites akustisches Volumen (312, 512, 1112, 1212) definieren, wobei der elektroakustische Wandler derart eingerichtet ist, dass eine erste Abstrahlfläche des Wandlers akustische Energie in das erste akustische Volumen abstrahlt, und derart, dass eine zweite Abstrahlfläche des Wandlers akustische Energie in das zweite akustische Volumen abstrahlt;
einen vorderen Port (532, 1132, 1232), der das erste akustische Volumen mit einem Raum außerhalb des Gehäuses koppelt; und
einen hinteren Port (534, 1134, 1234), der das zweite akustische Volumen mit dem Raum außerhalb des Gehäuses koppelt,
wobei jeweilige Auslassenden des hinteren Ports und des vorderen Ports zusammenlaufen, bevor sie über ein kombiniertes Austrittsvolumen (536, 1136, 1236) und einen Austrittsport (538, 1138, 1238) aus dem Gehäuse austreten.

2. Hörgerät (100, 700) nach Anspruch 1, wobei der elektroakustische Wandler ein Vollbereichswandler ist.

3. Hörgerät (100, 700) nach Anspruch 2, wobei der elektroakustische Wandler ein beweglicher Spulenwandler ist.

4. Hörgerät (100, 700) nach Anspruch 1, wobei die Elektronik einen Transceiver einschließt, der die Übertragung von High-Fidelity-Audio unterstützt.

5. Hörgerät (100, 700) nach Anspruch 1, wobei das Mikrofon vom Gehäuse getragen wird und wobei die Verkabelung das Mikrofon elektrisch mit der Elektronik koppelt.

6. Hörgerät (100, 700) nach Anspruch 5, wobei das Mikrofon ein Rückkopplungsmikrofon ist, das zum Aufnehmen von Ton am Gehörgang des Benutzers eingerichtet ist.

7. Hörgerät (100, 700) nach Anspruch 5, wobei das Mikrofon ein Vorwärtskopplungsmikrofon ist, das so eingerichtet ist, dass es zur Vorwärtskopplungs-Geräuschunterdrückung akustisch mit der Luft in der Nähe der Ohrmuschel des Benutzers gekoppelt ist.

8. Hörgerät (100, 700) nach Anspruch 7, ferner umfassend ein zweites Mikrofon, das von der Außenhülle getragen wird.

9. Hörgerät (100, 700) nach Anspruch 8, wobei das zweite Mikrofon ein Mikrofonarray umfasst.

10. System (800), umfassend:
das Hörgerät (700) nach einem der vorhergehenden Ansprüche; und
eine Computervorrichtung (802), die kommunikativ mit dem Hörgerät gekoppelt und so konfiguriert ist, dass sie ein Softwareprogramm ausführt, das es einem Benutzer ermöglicht, eine oder mehrere Funktionen des Hörgeräts anzupassen.

11. System nach Anspruch 10, wobei das Softwareprogramm es einem Benutzer ermöglicht, Signalverarbeitungsparameter des Hörgeräts anzupassen.

12. System nach Anspruch 11, wobei die Signalverarbeitungsparameter Filterkoeffizienten für den aktiven Rauschunterdrückungsalgorithmus einschließen.

## Revendications

1. Prothèse auditive (100, 700) comprenant :
un transducteur électroacoustique (308, 508, 1108, 1208) ;
un logement (306, 506, 1106, 1206) supportant le transducteur électroacoustique et
dimensionné pour se placer au moins partiellement dans le conduit auditif d'un utilisateur ;
de l'électronique (706) ;
un boîtier (104, 704) supportant l'électronique et configuré pour se placer derrière le pavillon d'un utilisateur lorsqu'il est porté ;
un câblage (718) s'étendant entre le boîtier et le logement et couplant électriquement l'électronique au transducteur électroacoustique ;
un microphone (720, 722) supporté par le boîtier, dans laquelle l'électronique est configurée pour exécuter un algorithme d'annulation de bruit active pour produire un signal qui amène le transducteur électroacoustique à produire de l'énergie acoustique pour annuler le bruit sur la base d'une entrée provenant du microphone,
la prothèse auditive comprenant en outre un écouteur (300, 500, 900, 1100, 1200), l'écouteur comprenant :
le transducteur électroacoustique ;
le logement supportant le transducteur électroacoustique de telle sorte que le logement et le transducteur électroacoustique définissent ensemble un premier volume acoustique (310, 510, 1110, 1210) et un second volume acoustique (312, 512, 1112, 1212), le transducteur électroacoustique étant agencé de telle sorte qu'une première surface rayonnante du transducteur émette de l'énergie acoustique dans le premier volume acoustique et de telle sorte qu'une seconde surface rayonnante du transducteur émette de l'énergie acoustique dans le second volume acoustique ;
un orifice avant (532, 1132, 1232) couplant le premier volume acoustique à un espace à l'extérieur du logement ; et
un orifice arrière (534, 1134, 1234) couplant le second volume acoustique à l'espace à l'extérieur du logement,
dans laquelle des extrémités d'évacuation respectives de l'orifice arrière et de l'orifice avant se combinent avant de sortir du logement via un volume de sortie combiné (536, 1136, 1236) et un orifice de sortie (538, 1138, 1238).

2. Prothèse auditive (100, 700) selon la revendication 1, dans laquelle le transducteur électroacoustique est un transducteur à gamme étendue.

3. Prothèse auditive (100, 700) selon la revendication 2, dans laquelle le transducteur électroacoustique est un transducteur à bobine mobile.

4. Prothèse auditive (100, 700) selon la revendication 1, dans laquelle l'électronique comprend un émetteur-récepteur qui prend en charge la transmission d'audio haute-fidélité.

5. Prothèse auditive (100, 700) selon la revendication 1, dans laquelle le microphone est supporté par le logement et dans laquelle le câblage couple électriquement le microphone à l'électronique.

6. Prothèse auditive (100, 700) selon la revendication 5, dans laquelle le microphone est un microphone à rétroaction agencé pour capter l'audio au niveau du conduit auditif de l'utilisateur.

7. Prothèse auditive (100, 700) selon la revendication 5, dans laquelle le microphone est un microphone à anticipation agencé pour être couplé acoustiquement à l'air adjacent au pavillon de l'utilisateur pour une annulation de bruit à anticipation.

8. Prothèse auditive (100, 700) selon la revendication 7, comprenant en outre un second microphone supporté par le boîtier.

9. Prothèse auditive (100, 700) selon la revendication 8, dans laquelle le second microphone comprend un réseau de microphones.

10. Système (800) comprenant :
la prothèse auditive (700) selon l'une quelconque des revendications précédentes ; et
un dispositif informatique (802) couplé de manière communicante à la prothèse auditive et configuré pour exécuter un programme logiciel qui permet à un utilisateur d'ajuster une ou plusieurs caractéristiques de la prothèse auditive.

11. Système selon la revendication 10, dans lequel le programme logiciel permet à un utilisateur d'ajuster des paramètres de traitement de signal de la prothèse auditive.

12. Système selon la revendication 11, dans lequel les paramètres de traitement de signal comprennent des coefficients de filtre pour l'algorithme d'annulation de bruit active.
